# EUROPÄISCHE PATENTSCHRIFT

(11) **EP 1 783 846 B1**
(45) Veröffentlichungstag und Bekanntmachung des Hinweises auf die Patenterteilung: **09.07.2008**
(21) Anmeldenummer: 05023595.1
(22) Anmeldetag: 28.10.2005
(51) Int. Cl.: H01L 51/40

(54) **Abscheiden einer Schicht aus dotiertem organischen Material auf einem Substrat**
Deposition of a doped organic material on a substrate
Dépôt d'une couche organique dopée sur un substrat.

(43) Veröffentlichungstag der Anmeldung: 09.05.2007
(73) Patentinhaber: Novaled AG, 01307 Dresden (DE)
(72) Erfinder: Werner, Ansgar, 01277 Dresden (DE); Leo, Karl, 01219 Dresden (DE); Böttcher, Horst, 01169 Dresden (DE); Wöhrle, Dieter, 28359 Bremen (DE); Thiel, Carolin, 28205 Bremen (DE); Wark, Michael, 30165 Hannover (DE)
(74) Vertreter: Bittner, Thomas L.

(56) Entgegenhaltungen:
- EP-A- 0 561 016
- EP-A- 0 842 711
- EP-A- 1 337 132
- ROMPF C ET AL: "GROWTH AND CHARACTERIZATION OF ORGANIC SEMICONDUCTOR DEVICES: PHOTODETECTORS AND LIGHT EMITTING DIODES (OLEDS)" EXTENDED ABSTRACTS OF THE INTERNATIONAL CONFERENCE ON SOLID STATE DEVICES AND MATERIALS, JAPAN SOCIETY OF APPLIED PHYSICS. TOKYO, JA, 21. August 1995 (1995-08-21), Seiten 455-457, XP000544668
- PFEIFFER M ET AL: "DOPED ORGANIC SEMICONDUCTORS: PHYSICS AND APPLICATION IN LIGHT EMITTING DIODES" ORGANIC ELECTRONICS, ELSEVIER, AMSTERDAM, NL, Bd. 4, Nr. 2/3, September 2003 (2003-09), Seiten 89-103, XP001177135 ISSN: 1566-1199
- SHAO YAN ET AL: "White organic light-emitting diodes prepared by a fused organic solid solution method" APPLIED PHYSICS LETTERS, AIP, AMERICAN INSTITUTE OF PHYSICS, MELVILLE, NY, US, Bd. 86, Nr. 7, 10. Februar 2005 (2005-02-10), Seiten 73510-73510, XP012066408 ISSN: 0003-6951

## Beschreibung

Die vorliegende Erfindung betrifft ein Verfahren zum Herstellen einer Schicht aus einem dotierten organischen Material auf einem Substrat mittels Abscheiden, wobei das dotierte organische Material mindestens ein Matrixmaterial und mindestens ein Dotierungsmaterial enthält, sowie Verwendungen desselben und eine im Verfahren einsetzbare Mischung.

Dotierte organische Schichten können beispielsweise bei organischen Leuchtdioden (organic light emitting diodes, OLED) vorgesehen sein. Hierbei sind verschiedene Arten dotierter Schichten zu unterscheiden. Ladungsträgertransportschichten werden mit starken Donor- bzw. starken Akzeptorverbindungen dotiert (elektrische Dotierung). Es wird mittels eines Ladungstransfers zwischen Matrixmaterial und Dotierungsmaterial eine erheblich höhere Leitfähigkeit dieser Schichten für Elektronen oder Löcher erzeugt. Dieses verbessert die elektrischen Eigenschaften organischer Leuchtdioden dahingehend, daß eine geringere Betriebsspannung für eine bestimmte Helligkeit benötigt wird. Darüber hinaus ergeben sich eine Vielzahl weiterer Vorteile, beispielsweise eine bessere Ladungsträgerinjektion aus den Elektroden, für deren Herstellung deshalb eine weitere Auswahl an Materialien z.B. hinsichtlich ihrer Austrittsarbeit oder ihrer Prozesskompatibilität in Frage kommt. Weiterhin können die Dicken der so dotierten Schichten in einem weiten Bereich variiert werden, ohne daß ohmsche Verluste in den Transportschichten die Leistung des Bauelements beeinträchtigen. So kann beispielsweise die Schichtdicke so gewählt werden, daß das im Bauelement entstehende Licht durch konstruktive Interferenz optimal aus dem Bauelement ausgekoppelt wird.

Für solche dotierte Schichten werden häufig molare Konzentrationen von Dotierungsmaterial zu Matrixmaterial im Bereich von 1:1 bis 1:10.000, bevorzugt zwischen 1:10 und 1:200, gewählt. Dotierte organische Halbleiterschichten werden auch in anderen organischen Bauelementen wie zum Beispiel organischen Solarzellen oder organischen Dünnschicht-Transistoren (thin film transistors, TFT) eingesetzt. Eine solche dotierte Schicht kann beispielsweise aus einer Mischung von 4,4,4-Tris(3-methylphenylphenylamino)tri-phenylamin (m-MTDATA) und Tetracyanotetrafluorochinodimethan (F4-TCNQ) im molaren Verhältnis 50:1 bestehen. Eine andere Ausprägung einer solchen dotierten Schicht kann aus Bathophenanthroline (BPhen) und Cäsium im molaren Verhältnis von beispielsweise 8:1 bestehen.

Eine weitere Art der Dotierung sieht das Einmischen von lichtemittierenden Dotanden in ein Matrixmaterial vor (Tang et al., J. Appl. Phys. 65, 3610 (1989)). Diese Mischung bildet dann die lichtemittierende Schicht in einer organischen Leuchtdiode. Solche dotierten Schichten weisen in der Regel eine höhere Lumineszenzquantenausbeute auf und erlauben es, das Spektrum des emittierten Lichtes zu beeinflußen. Für solche dotierten Schichten werden häufig Dotierkonzentrationen von 1:2 bis 1:1000, bevorzugt 1:10 bis 1:100, gewählt. Beispielsweise kann eine solche dotierte lichtemittierende Schicht aus 4,4',4"-Tris(N-carbazolyl)-triphenylamine (TCTA) und fac-Tris(2-phenylpyridine)iridium (Ir(ppy)₃) im Massenverhältnis 5:1 bestehen.

In organischen Solarzellen werden Mischschichten, sogenannte "bulk heterojunctions", eingesetzt, um eine höhere Quantenausbeute für die Umwandlung von Licht in Ladungsträger zu erreichen (Gebeyehu et al., Solar Energ. Mater. Solar Cells 79, 81 (2003)). Aufgrund der Absorption von Licht in organischen Materialien entsteht zunächst ein Elektron-Lochpaar mit einer sehr hohen Bindungsenergie. In reinen Materialien ist es deshalb schwierig, dieses so genannte Exziton in ungebundene Ladungsträger aufzuspalten. Deshalb wird eine Mischung aus donorartigen und akzeptorartigen Materialien eingesetzt. Das Exziton wird hierbei durch Ladungsübertrag vom Donor auf den Akzeptor aufgetrennt. Für solche dotierten Schichten werden häufig Dotierkonzentrationen von 1:1 bis 1:10 gewählt. Beispielsweise kann eine solche dotierte Schicht aus Phthalozyanin Zink und Fulleren C60 im molaren Verhältnis 2:1 bestehen. Weiterhin werden in organischen Solarzellen auch dotierte Transportschichten eingesetzt.

Schließlich wird in der Literatur berichtet, daß gemischte dotierte Schichten zur Erhöhung der Stabilität von organischen Bauelementen verwendet werden können (Shi et al., Appl. Phys. Lett. 70, 1665 (1997). Für einige Anwendungen von dotierten Halbleiterschichten sind auch Mischungen mit mehr als zwei Komponenten vorteilhaft (vgl. zum Beispiel US 6,312,836 B1, US 6,287,712).

Beim Herstellen organischer, dotierter Halbleiterschichten wird die organische Substanz in die gasförmige Phase überführt und dann abgeschieden. Prinzipiell können organische Substanzen entweder aus der flüssigen oder aus der festen Phase in die gasförmige Phase übergehen. Im ersten Fall spricht man vom Verdampfen, im zweiten Fall von Sublimation. Im Folgenden werden beide Bezeichnungen synonym verwendet und sollen jeweils sowohl das Aufdampfen aus der festen als auch der flüssigen Phase umfassen.

Dotierte organische Schichten werden bisher mittels Mischverdampfung hergestellt. Hierbei werden Matrixmaterial und Dotierungsmaterialien in jeweilige Verdampfungsquellen (Verdampfer) gefüllt und unter Fein- oder Hochvakuumbedingungen zur selben Zeit sublimiert. Der Dampf aus den zwei (oder mehreren, je nach Zahl der Dotiersubstanzen) Verdampfungsquellen wird auf einem Substrat abgeschieden. In Abhängigkeit von den gewählten Verdampfungsraten, der Abstrahlcharakteristik der Verdampfungsquellen und der Geometrie der Anordnung ergeben sich bestimmte Mischungsverhältnisse der entstehenden Schicht.

Dieses Verfahren weist eine Reihe von Nachteilen auf. Es ist notwendig, die Aufdampfraten der Verdampfungsquellen während des gesamten Verdampfungsprozesses sehr genau zu kontrollieren, um eine homogene Dotierung zu erreichen. Die Temperaturen der einzelnen Verdampfer müssen oft auf sehr verschiedene Temperaturen eingestellt werden, um bei den gegebenen unterschiedlichen Dampfdrücken der einzelnen Substanzen die notwendigen Verdampfungsraten zu erhalten; dies schafft oft thermische Probleme oder führt zu einer Kreuzkontamination der Quellen. Weiterhin müssen die Abstrahlcharakteristik und die Anordnung der Verdampfungsquellen so beschaffen sein, daß auf der ganzen Fläche des Substrates das Verhältnis der Flüsse von Matrixmaterial und Dotanden konstant ist. Dieses ist vor allem für Substrate mit einer großen Grundfläche nur sehr aufwändig zu gewährleisten. Weiterhin ergibt sich für jede dotierte Schicht die Notwendigkeit, einen oder mehrere zusätzlichen Verdampfer für die Dotanden bei der Projektierung einer Verdampfungsanlage vorzusehen. Nicht zuletzt erhöht sich der Wartungsaufwand für eine solche Anlage beträchtlich. Schließlich ergibt sich ein deutlich erhöhter Aufwand an Regeltechnik für den Betrieb der Verdampfer.

Weiterhin sind Verfahren zur Herstellung einer Mischschicht aus Wirts- und Gastmaterialien bekannt, bei denen eine Mischung dieser Materialien direkt verdampft wird (S.A. van Slyke et al., US2003/0008071A1). Der Nachteil dieses Verfahrens ist es, daß sich die Verdampfungstemperaturen der beteiligten Materialien sehr ähnlich sein müssen, da es andernfalls zu einer aufeinanderfolgenden Verdampfung jeweils des Wirts- bzw. des Gastmaterials kommt. Weiterhin kann es durch den engen Kontakt zwischen Wirts- und Gastmaterial zu unerwünschten Nebenreaktionen kommen. Dies ist zum Beispiel der Fall, wenn zur Herstellung einer dotierten Löchertransportschicht ein donorartiges Wirtsmaterial mit einem akzeptorartigen Gastmaterial gemischt wird. Beispielsweise bildet sich bei der Mischung von 4,4',4"-tris-(3-methylphenylphenylamino)-triphenylamine (m-MTDATA) als donorartige Wirtssubstanz mit Tetrafluorotetracyanoquinodimethan als akzeptorartige Gastsubstanz ein Salz, das nicht mehr verdampft werden kann.

In der EP 0 842 711 A1 wird der Einsatz poröser Trägermaterialien beschrieben, die mit einem abzuscheidenden Material imprägniert sind, um durch Verdampfung dieses abzuscheidenden Materials eine Dünnschicht zu erstellen. Diese Dünnschicht kann auf einem Basisbauteil aufgebracht werden und soll farbdichte, wasserdichte, staubdichte Dünnschichten bereitstellen. Bevorzugt kann hier Gips mit einer Korngrößenverteilung von 1 bis 100 µm eingesetzt werden.

Aufgabe der vorliegenden Erfindung ist es, ein gattungsgemäßes Verfahren bereitzustellen, das die Nachteile des Stands der Technik überwindet. Insbesondere soll ein Verfahren bereitgestellt werden, bei dem eine genaue Kontrolle der Aufdampfraten der Verdampfungsquellen während des Verdampfungsprozesses nicht mehr erforderlich ist, die Einstellung unterschiedlicher Temperaturen für einzelne Verdampfer nicht mehr nötig ist und eine gut Abstrahlcharakteristik der Verdampferquellen geschaffen wird, um ein gleichmäßiges Abscheiden zu ermöglichen. Insbesondere soll das Verfahren das einfache und kontrollierte Abscheiden einer Schicht für eine organische Leuchtdiode ermöglichen. Schließlich ist es eine weitere Aufgabe der vorliegenden Erfindung, Verwendungsmöglichkeiten für das Verfahren anzugeben.

Diese Aufgabe wird durch ein Verfahren mit den Merkmalen des unabhängigen Anspruchs 1 gelöst.

Vorteilhafte Ausgestaltungen der Erfindung sind Gegenstand von abhängigen Unteransprüchen.

Vorteilhafte Verwendungsmöglichkeiten ergeben sich aus den Ansprüchen 14 bis 17. Mischungen ergeben sich aus dem Ansprüchen 18 und 19.

Erfindungsgemäß wird ein Verfahren zum Herstellen einer Schicht aus einem dotierten Halbleitermaterial auf einem Substrat mittels Abscheiden vorgeschlagen, wobei das dotierte Halbleitermaterial mindestens ein Matrixmaterial und mindestens ein Dotierungsmaterial enthält, wobei mindestens eine der Substanzen, die verdampft werden sollen, in die Kanäle oder Hohlräume einer oder mehrerer Trägersubstanzen (Käfigmaterialien), die im wesentlichen nicht Bestandteil der Schicht werden, vor der Überführung in die Dampfphase eingelagert ist und aus dieser verdampft wird. Die Trägersubstanz ist vorzugsweise nicht oder nur in geringem Umfang verdampfbar. Als organische Trägersubstanzen kommen bevorzugt solche in Frage, die eine ausreichend hohe Sublimationstemperatur aufweisen. Eine organische Trägersubstanz sollte zumindest eine Sublimationstemperatur von 200°C, vorteilhafterweise mindestens 400°C aufweisen.

Mit dem vorgeschlagenen Verfahren wird die Herstellung von dotierten Schichten vereinfacht. Die Eigenschaften der molekularen Flüsse können gezielt gesteuert werden, weil die Freigabe der in den Trägersubstanzen eingelagerten Materialien durch Parameter wie Porengröße oder Porenweite und Wechselwirkung mit den Gitteratomen des Trägermaterials gezielt eingestellt werden kann und bei der Verdampfung aus derselben Verdampfungsquelle eine von den Dampfdrücken der Ausgangssubstanzen unabhängige Einstellung der Raten möglich ist. Das Verhältnis der Verdampfungsraten ist weitgehend zeitunabhängig, da nur noch eine Temperatur zu kontrollieren ist. Weiterhin können Verdampferanlagen zum Ausführen des Verfahrens vereinfacht ausgestaltet werden. Es entfällt der Aufwand für mindestens eine Verdampfungsquelle bei Planung und Betrieb der Verdampferanlage zur Herstellung von Bauelementen mit dotierten Halbleiterschichten, insbesondere bei der Herstellung von Bauelementen mit organischen Schichten wie organische Leuchtdioden.

Weiterhin ist es beim vorgeschlagenen Verfahren möglich, auch Substanzen aus einer Quelle als Mischung zu verdampfen, wenn diese bei direkter Mischung bereits in der Verdampfungsquelle unerwünschte Reaktionen ausführen. Solche Reaktionen finden beispielsweise bei der elektrischen Dotierung in der Regel statt, da für eine Dotierung beispielsweise starke donorartige Moleküle mit akzeptorartigen Molekülen oder stark akzeptorartige Moleküle mit donorartigen Molekülen zusammengebracht werden. Eine solche Konstellation führt häufig zu einer Übertragung von Elektronendichte von der einen Molekülsorte auf die andere. Die entstehende Verbindung kann beispielsweise als Charge-Transfer-Komplex oder als Radikalionensalz oder allgemein als Salz bezeichnet werden. Sie kann eine sehr hohe Gitterenergie aufweisen, beispielsweise durch die elektrostatische Anziehung der Anionen und Kationen des Salzes. Dies kann dazu führen, dass sich solche Verbindungen bis zur Zersetzungstemperatur nicht verdampfen lassen. Wird zum stark akzeptorartigen gelben Molekül F4TCNQ das donorartige weisse Molekül m-MTDATA durch Verreiben gemischt, entsteht ein dunkles Pulver. Dieses Pulver kann bis 400°C nicht verdampft werden, obwohl beide Komponenten jeweils einzeln bereits unterhalb von 250°C abgeschieden werden können. Das vorgeschlagene Verfahren kann es ermöglichen, solche unerwünschten Effekte in der Verdampferquelle zu verhindern.

Neben der oben beschriebenen Unterdrückung unerwünschter Nebenreaktionen zwischen gleichzeitig verdampften Komponenten ist es mit dem erfindungsgemäßen Verfahren ebenfalls möglich, mögliche störende Einflüsse der Umgebungsatmosphäre, wie beispielsweise Sauerstoff oder Luftfeuchte, auf die in der Trägersubstanz eingebetteten Materialien zu reduzieren, da die Materialien durch diese Einlagerung oder Einbettung vor der Umgebungsatmosphäre besser geschützt werden können.

Neben Emitterdotanden können auch Redox-Dotanden als Dotierungsmaterial eingesetzt werden.

Das erfindungsgemäße Verfahren ist in Verbindung mit unterschiedlichen Verfahrensgestaltungen nutzbar. So können neben einer Verdampfung mittels Zuführen thermischer Energie auch die Nutzung von Laserlichtimpulsen und die Molekularstrahlepitaxie vorgesehen sein.

Gelegentlich werden Mischungen von organischen Materialien mit keramischen oder metallischen Werkstoffen zur Verwendung für Aufdampfprozesse vorgeschlagen (J. Kido et al., US2001/0021415; S. A. van Slyke et al., US2003/0008071A1; S. K. Gosh et al., US2003/0153109A1). Dies führt zu einer erhöhten Wärmeleitfähigkeit der Mischung im Vergleich zum reinen organischen Material. Damit erreicht man eine effektiv geringere Verdampfungstemperatur des zu verdampfenden organischen Materials. Der thermische Stress des Materials wird verringert und eine homogenere Verdampfung in großflächigen Verdampferquellen erreicht. Demgegenüber wird in der vorliegenden Erfindung eine effektiv höhere Verdampfungstemperatur des zu verdampfenden Materials angestrebt. Dies wird insbesondere durch die poröse Struktur der beteiligten Trägermaterialien und durch die geringe Dimension der Poren erreicht. Weiterhin wird durch die spezielle Art der Vermischung von organischen Material und dem Trägermaterial sichergestellt, dass die organische Substanz in die Poren eindringen kann bzw. eingebaut wird, was die Erhöhung der Verdampfungstemperatur zur Folge hat.

Die Erfindung wird im folgenden anhand von Ausführungsbeispielen näher erläutert.

### Ausführungsbeispiel 1

### Immobilisierung von Rubren in einer SiO₂-Matrix

In einem ersten bevorzugten Ausführungsbeispiel soll eine zur Erhöhung der Quanteneffizienz dotierte Emitterschicht für eine organische Leuchtdiode hergestellt werden. Dazu werden die Substanzen Rubren als Gast und Tris(8-hydroxychinolin)aluminium (Alq3) als Wirt verwendet. Rubren hat eine Sublimationstemperatur von 250°C.

In 20 ml eines SiO₂-Nanosols (Feststoffgehalt 10 %; Lösungsmittel 67 Tl. Tetrahydrofuran/33 Tl. Ethanol) wurden 0,2 g Rubren (erhältlich von Aldrich) in 10 ml Tetrahydrofuran unter leichtem Erwärmen gelöst, 12 h gerührt und durch Zugabe von 3 Tropfen 25 % Ammoniak geliert. Das Gel wurde an der Luft getrocknet, gemörsert und dann 1 h bei 120°C getempert.

Aus dem erhaltenen hellroten Pulver sublimiert Rubren bei 300°C.

Die Trägersubstanz mit dem eingelagerten Dotanden kann mit dem Wirtsmaterial (Alq3) vermischt und aus einer üblichen Verdampferquelle verdampft werden, um die dotierte Emitterschicht zu bilden.

Neben den genannten Verbindungen kommen als Dotiersubstanz beispielsweise fluoreszente oder phosphoreszente Emittermoleküle, wie z.B. 4-(Dicyanomethylen)-2-methyl-6-(p-dimethylaminostyryl)-4H-pyran (DCM-1), Tris(phenyl-pyridyl)iridium, 3-(2-Benzthiazolyl)-7-diethylamino-coumarin oder Amino-substitutierte Distyrylarylene, und als Matrixsubstanz beispielsweise 1,4-Bis(2,2-diphenylvinyl)benzen, 4,4',4-Bis(carbazolyl-9-yl)-biphenyl, oder Aluminium(tris-8-hydroxyquinolin) in Frage.

### Ausführungsbeispiel 2

### Herstellung und Immobilisierung von Alq₃ in einer SiO₂-Al₂O₃-Matrix durch Reaktion von 8-Oxy-chinolin mit einem Al₂O₃-Nanosol

20 ml eines SiO₂-Nanosols (Feststoffgehalt 4.2 %; Lösungsmittel 70 % wässriges Ethanol) wurden mit 10 ml eines Al₂O₃-Nanosols (Feststoffgehalt 5.0 %; Lösungsmittel 50 % wässriges Ethanol) mit 5 ml einer Lösung von 5 % 8-Oxychinolin in 5,0 % wässrigem Ethanol gemischt und 3 h bei Raumtemperatur gerührt. Die Lösung bildet nach Tauchbeschichtung (30cm/min) auf Glas transparente Schichten, die nach Temperung zwischen 120-180°C das charakteristische Absorptionsspektrum von Alq3 (λmax ca. 370 nm) aufweisen.

Zur Herstellung von Bulk-Produkten wird die Lösung mit 0.1 n Natronlauge neutralisiert, das zu einer Gelierung nach ca. 60 min. führt. Das Gel wird an der Luft getrocknet, gemörsert und 1 h bei 120°C getempert und ergibt ein hellgelbes Pulver.

## Patentansprüche

1. Verfahren zum Herstellen einer Halbleiterschicht aus einem dotierten organischen Material auf einem Substrat mittels Abscheiden durch Verdampfen, wobei das dotierte organische Material mindestens ein Matrixmaterial und mindestens ein Dotierungsmaterial enthält, wobei in einer gemeinsamen Verdampfungsquelle eine Mischung aus Matrixmaterial und Dotierungsmaterial vorliegt und das Matrixmaterial und das Dotierungsmaterial gleichzeitig in eine Dampfphase überführt werden und als Mischung auf dem Substrat abgeschieden werden, **dadurch gekennzeichnet, daß** zumindest eine der zu verdampfenden Substanzen vor der Überführung in die Dampfphase in einer nanoporösen Trägersubstanz eingelagert ist und das zweite Material nicht eingelagert ist und beide Substanzen aus der gemeinsamen Verdampfungsquelle gleichzeitig verdampft werden.

2. Verfahren nach Anspruch 1, **dadurch gekennzeichnet, dass** die poröse Trägersubstanz eine anorganische Substanz ist.

3. Verfahren nach Ansprüchen 2, **dadurch gekennzeichnet, dass** die anorganische Substanz ausgewählt wird aus der Gruppe bestehend aus Zeolithen, Molekularsieben, Siliziumaluminiumphosphaten, Aluminiumphosphaten, Siliziumdioxid, Aluminiumoxid, Zirkoniumdioxid, Titandioxid, Faujasit oder einer Mischung derselben.

4. Verfahren nach einem der vorangehenden Ansprüche, **dadurch gekennzeichnet, daß** das mindestens eine Matrixmaterial eine höhere Verdampfungs/Sublimationstemperatur als das mindestens eine Dotierungsmaterial aufweist.

5. Verfahren nach einem der Ansprüche 1 bis 3, **dadurch gekennzeichnet, daß** das mindestens eine Matrixmaterial eine niedrigere Verdampfungs/Sublimationstemperatur als das mindestens eine Dotierungsmaterial aufweist.

6. Verfahren nach einem der vorangehenden Ansprüche, **dadurch gekennzeichnet, daß** das Matrixmaterial ausgewählt wird aus einem Material mit einer Verdampfungs-/Sublimationstemperatur, die sich von der Verdampfungs/Sublimationstemperatur des Dotierungsmaterials um mindestens etwa 100°C, vorzugsweise um mindestens etwa 150°C, noch bevorzugter um etwa 200°C unterscheidet.

7. Verfahren nach einem der vorangehenden Ansprüche, **dadurch gekennzeichnet, daß** die Einlagerung des Dotierierungsmaterials oder des Matrixmaterials in die Trägersubstanz durch eine Eindiffusion unter Vakuum oder Schutzgas bei einer Temperatur von etwa 100°C - 500°C durchgeführt wird.

8. Verfahren nach einem der Ansprüche 1-6, **dadurch gekennzeichnet, daß** die Einlagerung des Dotierungsmaterials oder des Matrixmaterials in die Trägersubstanz durch eine Eindiffusion aus der Lösung erfolgt.

9. Verfahren nach einem der vorangehenden Ansprüche 1-6, **dadurch gekennzeichnet, daß** die Einlagerung des Dotierungsmaterials oder des Matrixmaterials in die Trägersubstanz durch eine Eindiffusion aus der Schmelze erfolgt.

10. Verfahren nach einem der Ansprüche 1-6, **dadurch gekennzeichnet, daß** die Einlagerung des Dotierungsmaterials oder der Matrixmaterials in die Trägersubstanz in einem Sol-Gel-Verfahren erfolgt, wobei das Dotierungsmaterial oder Matrixmaterial bei der Synthese der Trägersubstanz zugesetzt wird.

11. Verfahren nach einem der vorangehenden Ansprüche, **dadurch gekennzeichnet, daß** die Mischung in der Verdampfungsquelle mittels Zuführen von thermischer Energie in die Dampfphase überführt wird.

12. Verfahren nach einem der Ansprüche 1-10, **dadurch gekennzeichnet, daß** die Mischung in der Verdampfungsquelle mittels kontinuierlichem oder gepulstem Einstrahlen von Licht in die Dampfphase überführt wird.

13. Verfahren nach einem der Ansprüche 1-10, **dadurch gekennzeichnet, daß** die Mischung des Matrixmaterials und des Dotierungsmaterials mittels Molekularstrahlepitaxie abgeschieden wird.

14. Verwendung des Verfahren nach einem der Ansprüche 1-13 zur Erzeugung einer mit einem lichtemittierenden Molekül dotierten Emitterschicht einer organischen Leuchtdiode.

15. Verwendung des Verfahrens nach einem der Ansprüche 1-13 zur Erzeugung einer dotierten Transportschicht einer organischen Leuchtdiode.

16. Verwendung des Verfahrens nach einem der Ansprüche 1-13 zur Erzeugung einer photoaktiven Schicht einer organischen Solarzelle.

17. Verwendung des Verfahrens nach einem der Ansprüche 1-13 zur Erzeugung einer dotierten Transportschicht einer organischen Solarzelle.

18. Mischung für die Verwendung in einem Verfahren gemäß Anspruch 1 - 17 bestehend aus zumindest einem, in einer porösen Trägersubstanz eingelagerten, verdämpfbaren, organischen Matrixmaterial und zumindest einem nicht eingelagerten verdampfbaren, organischen Dotierungsmaterial oder Mischung aus zumindest einem nicht eingelagerten verdampfbaren organischen Matrixmaterial und zumindest einem, in einer porösen Trägersubstanz eingelagerten verdampfbaren, organischen Dotierungsmaterial, wobei das Matrixmaterial ein Akzeptor und das Dotierungsmaterial ein Donor oder das Matrixmaterial ein Donor und das Dotierungsmaterial ein Akzeptor ist.

19. Mischung nach Anspruch 18, **dadurch gekennzeichnet, daß** Matrixmaterial und Dotierungsmaterial nach gleichzeitiger Verdampfung ein Salz bilden.

## Claims

1. Process for producing a semiconductor layer composed of a doped organic material on a substrate by means of deposition by evaporation, the doped organic material comprising at least one matrix material and at least one doping material, a mixture of matrix material and doping material being present in a combined evaporation source and the matrix material and the donor material simultaneously being converted to a vapour phase and being deposited on the substrate as a mixture, **characterized in that** at least one of the substances to be evaporated, before being converted to the vapour phase, is incorporated in a nanoporous carrier substance and the second material is not incorporated and the two substances are evaporated simultaneously from the combined evaporation source.

2. Process according to Claim 1, **characterized in that** the porous carrier substance is an inorganic substance.

3. Process according to Claim 2, **characterized in that** the inorganic substance is selected from the group consisting of zeolites, molecular sieves, silicon aluminium phosphates, aluminium phosphates, silicon dioxide, aluminium oxide, zirconium dioxide, titanium dioxide, faujasite or a mixture thereof.

4. Process according to one of the preceding claims, **characterized in that** the at least one matrix material has a higher evaporation/sublimation temperature than the at least one doping material.

5. Process according to one of Claims 1 to 3, **characterized in that** the at least one matrix material has a lower evaporation/sublimation temperature than the at least one doping material.

6. Process according to one of the preceding claims, **characterized in that** the matrix material is selected from a material having an evaporation/sublimation temperature which is different from the evaporation/sublimation temperature of the doping material by at least about 100°C, preferably by at least about 150°C, more preferably by about 200°C.

7. Process according to one of the preceding claims, **characterized in that** the incorporation of the doping material or of the matrix material into the carrier substance is carried out by diffusing it in under reduced pressure or protective gas at a temperature of about 100°C-500°C.

8. Process according to one of Claims 1-6, **characterized in that** the doping material or the matrix material is incorporated into the carrier substance by diffusing it in from solution.

9. Process according to one of preceding Claims 1-6, **characterized in that** the doping material or the matrix material is incorporated into the carrier substance by diffusing it in from melt.

10. Process according to one of Claims 1-6, **characterized in that** the doping material or the matrix material is incorporated into the carrier substance in a sol-gel process, the doping material or matrix material being added in the synthesis of the carrier substance.

11. Process according to one of the preceding claims, **characterized in that** the mixture is converted to the vapour phase in the evaporation source by means of supply of thermal energy.

12. Process according to one of Claims 1-10, **characterized in that** the mixture is converted to the vapour phase in the evaporation source by means of continuous or pulsed incidence of light.

13. Process according to one of Claims 1-10, **characterized in that** the mixture of the matrix material and of the doping material is deposited by means of molecular beam epitaxy.

14. Use of the process according to one of Claims 1-13 for obtaining an emitter layer of an organic light-emitting diode doped with a light-emitting molecule.

15. Use of the process according to one of Claims 1-13 for obtaining a doped transport layer of an organic light-emitting diode.

16. Use of the process according to one of Claims 1-13 for obtaining a photoactive layer of an organic solar cell.

17. Use of the process according to one of Claims 1-13 for obtaining a doped transport layer of an organic solar cell.

18. Mixture for use in a process according to Claims 1-17 consisting of at least one evaporable organic matrix material incorporated in a porous carrier substance and at least one unincorporated evaporable organic doping material, or mixture of at least one unincorporated evaporable organic matrix material and at least one evaporable organic doping material incorporated in a porous carrier substance, the matrix material being an acceptor and the doping material being a donor, or the matrix material being a donor and the doping material being an acceptor.

19. Mixture according to Claim 18, **characterized in that** matrix material and doping material form a salt after simultaneous evaporation.

## Revendications

1. Procédé pour la fabrication d'une couche à semi-conducteur en une matière organique dopée sur un substrat à l'aide d'une déposition par vaporisation, dans lequel la matière organique dopée contient au moins une matière de matrice et au moins une matière de dopage, un mélange constitué d'une matière de matrice et d'une matière de dopage étant présent dans une source de vaporisation commune et la matière de matrice et la matière de dopage étant simultanément transférées en phase vapeur et déposées sous forme de mélange sur le substrat, **caractérisé en ce qu'**au moins l'une des substances destinées à être vaporisées est incluse dans une substance porteuse nano-poreuse avant le transfert en phase vapeur et la seconde matière n'est pas incluse et les deux substances sont vaporisées simultanément à partir de la source de vaporisation commune.

2. Procédé selon la revendication 1, **caractérisé en ce que** la substance porteuse poreuse est une substance inorganique.

3. Procédé selon la revendication 2, **caractérisé en ce que** la substance inorganique est sélectionnée dans le groupe constitué par des zéolithes, des tamis moléculaires, des phosphates de silicium-aluminium, des phosphates d'aluminium, du dioxyde de silicium, de l'oxyde d'aluminium, du dioxyde de zirconium, du dioxyde de titane, de la faujasite ou d'un mélange de ceux-ci.

4. Procédé selon l'une quelconque des revendications précédentes, **caractérisé en ce que** la au moins une matière de matrice a une température de vaporisation/sublimation plus élevée que celle de la au moins une matière de dopage.

5. Procédé selon l'une quelconque des revendications 1 à 3, **caractérisé en ce que** la au moins une matière de matrice a une température de vaporisation/sublimation plus faible que celle de la au moins une matière de dopage.

6. Procédé selon l'une quelconque des revendications précédentes, **caractérisé en ce que** la matière de matrice est sélectionnée à partir d'une matière ayant une température de vaporisation/sublimation qui se différencie de la température de vaporisation/sublimation de la matière de dopage d'au moins environ 100°C, de préférence d'au moins environ 150°C, de manière davantage préférée d'au moins environ 200°C.

7. Procédé selon l'une quelconque des revendications précédentes, **caractérisé en ce que** l'inclusion de la matière de dopage ou de la matière de matrice dans la substance porteuse est réalisée par une diffusion à l'intérieur sous vide ou sous atmosphère protectrice à une température d'environ 100°C-500°C.

8. Procédé selon l'une quelconque des revendications 1 à 6, **caractérisé en ce que** l'inclusion de la matière de dopage ou de la matière de matrice dans la substance porteuse est réalisée par une diffusion à l'intérieur à partir de la solution.

9. Procédé selon l'une quelconque des revendications 1 à 6, **caractérisé en ce que** l'inclusion de la matière de dopage ou de la matière de matrice dans la substance porteuse est réalisée par une diffusion à l'intérieur à partir de la masse fondue.

10. Procédé selon l'une quelconque des revendications 1 à 6, **caractérisé en ce que** l'inclusion de la matière de dopage ou de la matière de matrice dans la substance porteuse est réalisée à l'aide d'un procédé sol-gel, dans lequel la matière de dopage ou la matière de matrice est ajoutée lors de la synthèse de la substance porteuse.

11. Procédé selon l'une quelconque des revendications précédentes, **caractérisé en ce que** le mélange dans la source de vaporisation est transféré en phase vapeur par l'alimentation d'énergie thermique.

12. Procédé selon l'une quelconque des revendications 1 à 10, **caractérisé en ce que** le mélange dans la source de vaporisation est transféré en phase vapeur par radiation continue ou pulsée de lumière.

13. Procédé selon l'une quelconque des revendications 1 à 10, **caractérisé en ce que** le mélange constitué par la matière de dopage et la matière de matrice est déposé par épitaxie par faisceau moléculaire.

14. Utilisation du procédé selon l'une quelconque des revendications 1 à 13, pour la production d'une couche émettrice dopée avec une molécule électroluminescente d'une diode électroluminescente organique.

15. Utilisation du procédé selon l'une quelconque des revendications 1 à 13, pour la production d'une couche de transport dopée d'une diode électroluminescente organique.

16. Utilisation du procédé selon l'une quelconque des revendications 1 à 13, pour la production d'une couche photo-active d'une cellule solaire organique.

17. Utilisation du procédé selon l'une quelconque des revendications 1 à 13, pour la production d'une couche de transport dopée d'une cellule solaire organique.

18. Mélange pour l'utilisation dans un procédé selon les revendications 1 à 17, constitué d'au moins une matière de matrice organique vaporisable incluse dans une substance porteuse poreuse et d'au moins une matière de dopage organique vaporisable non incluse ou mélange constitué d'au moins une matière de matrice organique vaporisable non incluse et d'au moins une matière de dopage organique vaporisable incluse dans une substance porteuse poreuse, la matière de matrice étant un accepteur et la matière de dopage étant un donneur ou la matière de matrice étant un donneur et la matière de dopage étant un accepteur.

19. Mélange selon la revendication 18, **caractérisé en ce que** la matière de matrice et la matière de dopage forment un sel après vaporisation simultanée.
